# EUROPEAN PATENT APPLICATION

(11) **EP 4 524 582 A1**
(43) Date of publication of application: **19.03.2025**
(21) Application number: 23425048.8
(22) Date of filing: 15.09.2023
(51) Int. Cl.: G01R 31/28

(54) **SHELL FOR WAFER LEVEL BURN-IN (WLBI) CHIP TEST, METHOD FOR LOADING SAID SHELL AND MACHINE FOR BURN-IN TEST COMPRISING SAID SHELL**

(71) Applicant: Microtest S.p.A., 56010 Vicopisano (PI) (IT)
(72) Inventor: AMELIO, Guiseppe, 55100 San Pietro (LU) (IT)
(74) Representative: Botti & Ferrari S.p.A.

(57) **Abstract**

A shell (1) for wafer (W) level burn-in chip test, comprising:
- a base (2) configured to connect to a BID, comprising a printed circuit of the base (20) electrically connectable to said BID and a probe head (23) provided with a plurality of probes (22) which are intended to contact respective pads of a wafer to be tested (W);
- a cover (3), at least partially separable from said base (2), said cover (3) comprising an integrated heater (31);
wherein, in a test configuration, said cover (3) is rigidly constrained to said base (2) with a wafer to be tested (W) interposed between the base (2) and the cover (3), said heater (31) being configured for heating said wafer to be tested (W) during a burn-in test.

## Description

### Field of Application

The present invention relates to a machine for burn-in tests, in particular a machine to carry out burn-in tests on integrated electronic circuits directly at a wafer level.

Said machines are used in the production phase of integrated electronic circuits to identify and discard any defective circuits directly at a wafer level.

In this type of test, the devices, i.e. the single chips, are thus still joined in groups: this assembly of devices is precisely called a wafer. In the subsequent steps of the process of production and qualification, the devices will be divided and undergo the packaging process. The machine according to the present invention is thus used to carry out electrical wafer level burn-in tests, whose purpose is to select the devices produced by identifying those that, due to internal defects, are destined to break prematurely (the phenomenon of "infant mortality"). Carrying out said tests before finishing the process of dividing and packaging allows economic saving.

More in particular, the invention relates to a shell of said machine, wherein the shell is a component that can be extracted from the machine and that is intended to house the wafer to be tested when the burn-in tests are carried out.

### Prior art

In the field of the invention, the use of cartridges into which the single wafers to be tested are loaded is known. Said cartridges are introduced into designated slots of a test machine, wherein they electrically connect to a test board intended to send test signals to the single devices that are on the wafer.

To carry out the burn-in tests, the machine comprises a heating system intended to bring the devices to a desired temperature to simulate a thermal stress.

Although they substantially meet the needs of the field, nevertheless the cartridge-based machines according to the prior art have some drawbacks that are thus far still not solved, related in particular to the energy consumption and to the speed of loading and unloading operations of the machine.

The technical problem underlying the present invention is thus to solve the reported drawbacks of the prior art, providing a device that allows to carry out wafer level burn-in tests with a reduced expenditure of energy and a corresponding loading method that allows to speed up the operations in the context of a chain of production of electronic devices.

### Summary of the invention

The solution idea underlying the present invention is to integrate directly on board of the shell housing the wafer a heater acting on said wafer. In this way, the heater may be brought in direct contact with the wafer to be tested, thereby minimizing thermal dispersions and allowing a substantial energy saving.

Based on the above solution idea, the technical problem is solved by a shell for wafer level burn-in chip test, comprising:
- a base configured to connect to a burn-in circuit board (Burn-In Driver, hereinafter defined with the acronym "BID"), comprising a printed circuit of the base electrically connectable to said BID and a probe head provided with a plurality of probes which are intended to contact respective pads of a wafer to be tested;
- a cover, at least partially separable from said base, said cover comprising an integrated heater;
wherein, in a test configuration, said cover is rigidly constrained to said base with a wafer to be tested interposed between the base and the cover, said heater being configured for heating said wafer to be tested during a burn-in test.

A technology without a main oven of the test machine, or anyway without a heat source external to the shell, is thus obtained.

Thanks to said expedient, the heater may be put directly in contact with the wafer to be tested in the test configuration.

Preferably, the cover comprises an aspiration system configured to create vacuum in a volume comprised between a wafer-side surface of the heater and the wafer to be tested, so as to hold the wafer to be tested against the heater.

Preferably, the aspiration system is integrated in said heater, said aspiration system comprising ducts that pass through the wafer-side surface of the heater.

In particular, the heater may comprise a resistor arranged in a volume crossed by said ducts; in other words, the resistor will follow a path that surrounds or flanks said aspiration ducts.

The base may comprise at least one upstream electrical connector for the electrical connection to the BID and at least one downstream electrical connector for the electrical connection to the cover, said at least one downstream electrical connector being configured to feed said heater. Thanks to said expedient, the heater may be controlled and fed from the BID, without however it is required to provide a direct electrical connection between said BID and the cover that integrates the heater.

Preferably, the cover comprises a system of mechanical pre-alignment for guiding a robotic handling device in positioning the wafer to be tested at the heater.

The above-mentioned system of mechanical pre-alignment may comprise a calibrated pin arranged to align with a notch of the wafer to be tested and/or a guiding profile intended to guide a flat of the wafer to be tested into a housing seat.

Preferably, the mechanical pre-alignment is in any case followed by a fine alignment of the wafer to ensure the micrometrical correspondence between the pads of the wafer and the probes of the base, preferably carried out with an automatic vision system.

The base and the cover may be hinged with each other in a book-like manner or may be totally unconstrained one by the other.

The probes of the cover are preferably made as electrical contacts of the pogo-pin type.

In an embodiment, the cover comprises side indentations that are lateral with respect to a housing seat of the wafer to be tested, said side indentations being configured to allow the grippers of a robotic handling device to access.

In another embodiment, the cover comprises turrets that can be extracted with respect to the wafer-side surface of the heater to assist the robotic handling device in positioning the wafer to be tested. The turrets may be retracted with a pneumatic or hydraulic operation system in such a way to put the wafer onto its housing seat.

The technical problem according to the present invention is also solved by a movable rack for wafer level burn-in chip test comprising a plurality of housing compartments, preferably slots, and a plurality of shells according to any one of the previous claims which can be housed in an extractable way in said housing compartments.

The technical problem is also solved by a burn-in station comprising said rack, which may be disengaged from the station for loading and unloading operations.

Preferably, neither the burn-in station nor the rack comprises additional heating systems other than the heaters that are integrated in the shells.

The technical problem is also solved by a loading/unloading machine that integrates said rack and the plurality of shells, and that comprises a path for loading/unloading the shells constrained to the BIDs in clean chamber. Inside the clean chamber, systems for opening the shells and mechanical handling devices for the extraction and the positioning of the wafers onto the covers are provided.

The technical problem is also solved by a method for loading the shell, which may be carried out, for example, by the above-mentioned loading/unloading machine.

Said method comprises the steps of:
- arranging the shell with base and cover separated from each other;
- orienting said cover with the wafer-side surface of the heater facing upwards;
- positioning, by means of a robotic handling device, a wafer to be tested into a housing seat arranged over said heater;
- locking said wafer to be tested in the housing seat on the heater;
- positioning the cover with the wafer to be tested over the base;
- making the cover integral with the base.

The step of locking said wafer to be tested in the housing seat on the heater may be advantageously use an aspiration system.

The step of positioning the wafer to be tested into the housing seat may advantageously involve a mechanical pre-alignment, followed by a fine alignment by means of a vision system carried out before positioning the cover with the wafer to be tested over the base.

The features and advantages of the probe head and of the corresponding method of assembly will become clearer from the description of the following embodiments given by way of non-limiting example with reference to the appended drawings.

### Brief Description of the Drawings

Figure 1 shows a perspective view of a burn-in station according to the present invention;
Figure 2 shows a perspective view of a rack of the burn-in station according to the present invention;

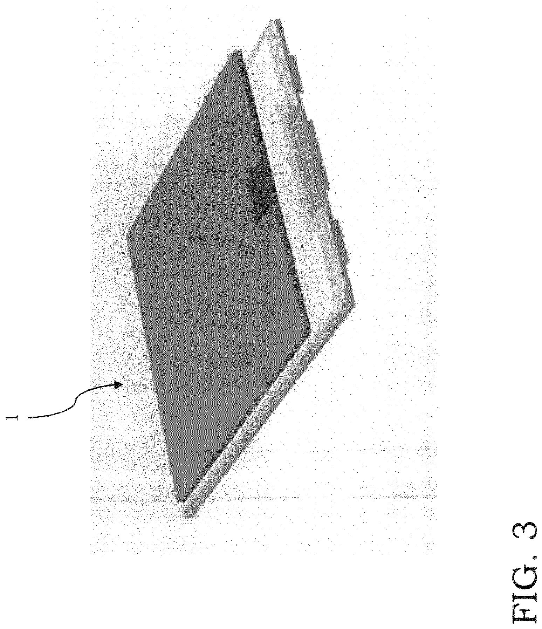

Figure 3 shows a perspective view of an embodiment of a shell according to the present invention in test configuration;
Figure 4 shows a perspective view of a shell according to the present invention in an open configuration of loading/unloading;
Figure 5 shows a perspective view of the shell of Figure 4 in open configuration during a step of loading of the wafer to be tested;
Figure 6 shows a perspective view of the shell of Figure 4 in open configuration, omitting the outer casing of the base to highlight the presence of some inner elements;

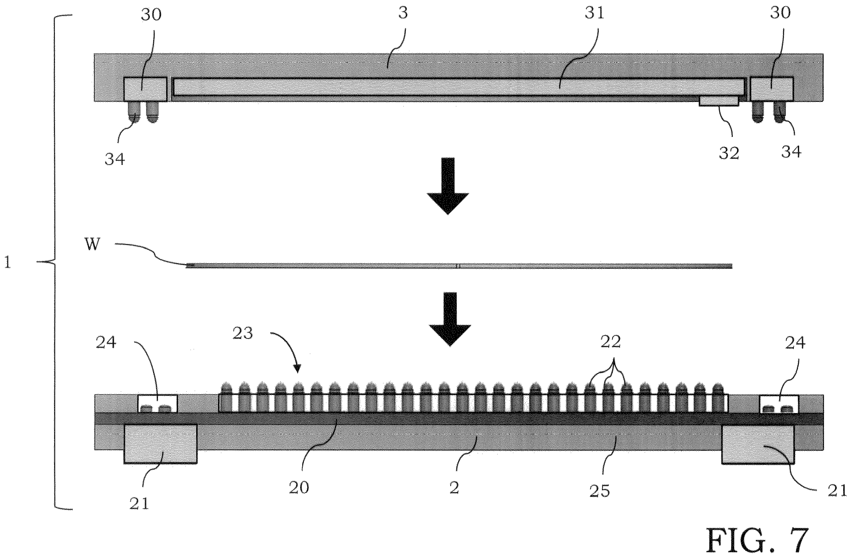

Figure 7 shows a schematic sectional view of an embodiment of the shell according to the present invention in open configuration with a wafer interposed between the base and the cover;
Figure 8 shows a schematic sectional view of the cover of the shell according to the present invention with the detail of the integrated aspiration system;
Figure 9 shows a schematic view, in an inverted loading position, of the cover of the shell according to an embodiment of the present invention;
Figure 10 shows a schematic view, in an inverted loading position, of the cover of the shell according to an embodiment of the present invention that is alternative to the one of Figure 9;
Figure 11 shows the operative diagram of a test cell comprising a rack which is movable between a burn-in station and a loading/unloading machine according to the present invention;
Figure 12 shows a detailed operative diagram of the loading/unloading machine of a rack according to the present invention.

### Detailed description

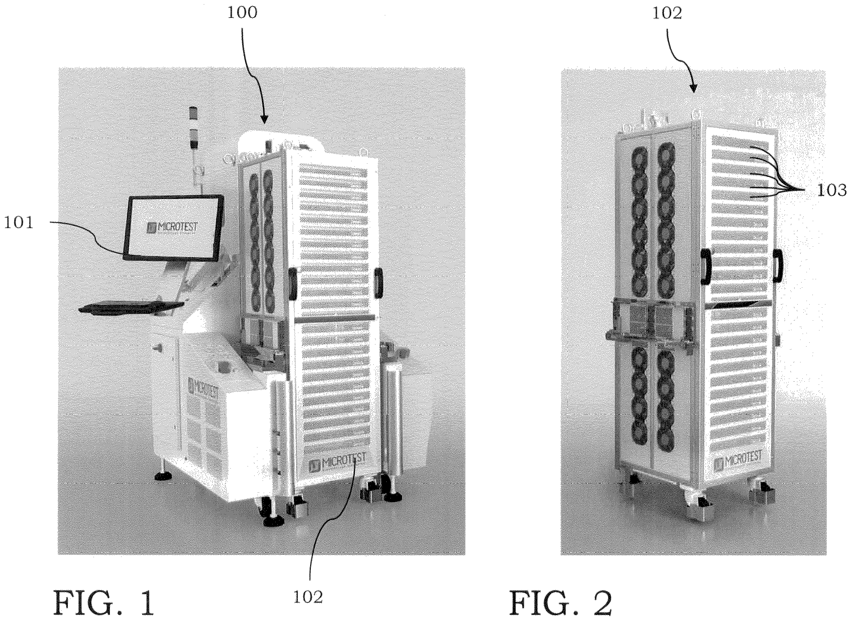

With reference to Figure 1 of the attached drawings, reference number 100 indicates a burn-in station, hereinafter identified with the acronym BIS, comprising a user interface 101 and arranged to receive at least one rack 10, separately depicted in Figure 2.

The burn-in station, as specified in the field of application of the present invention, is arranged to carry out burn-in tests on integrated electronic circuits directly at a wafer level.

The rack 10 has a plurality of overlaid housing compartments 11, in the preferred embodiment depicted in the figures up to twenty-four slots, arranged to house the burn-in wafer shells 1 - below simply identified as shells - according to the present invention.

The shell 1 is an assembly of components that allows to electrically and mechanically interface a wafer W to be tested to a burn-in circuit board 5 containing all the electrical resources required to carry out the burn-in test.

The shell 1 also contains, as it will be more extensively discussed below, the source of thermal power required to bring the wafer W to the test temperature.

The shell comprises two parts that are mechanically and electrically coupled: a base 2 and a cover 3. In use, the wafer W to be tested is aligned and fixed on the cover 3, therefore it is between the base 2 and the cover 3 when they are subsequently coupled.

It is noted that the terms base 2 and cover 3 do not imply any relative position between the two elements in the vertical direction.

The base 2 contains a printed circuit of the base 20 connected to a plurality of upstream electrical connectors 21 to electrically interface with BID 5.

A plurality of probes 22 stand from the wafer-side surface of the printed circuit of the base 20, the probes being preferably characterized by contacts of the elastic type and intended to make the electrical connection with the devices that are on the wafer W when said wafer W comes into contact with the base 2. The probes 22 may consist of retractable contacts, contact clips of the pogo-pin type.

The above-mentioned probes 22 are held in place by an assembly of mechanical components that on the whole take the name of probe head 23. The probe head 23 of the shell 1 according to the present invention may be preferably but not necessarily made according to the procedures described in European Patent Application no. 22211705.3, filed in the name of the Applicant.

The base 2 also comprises, at the wafer-side surface of the printed circuit of the base 20, a plurality of downstream electrical connectors 24, not necessarily identical to the previous ones, that connect to corresponding electrical connectors 34 of the cover 3 to allow the electrical connection between the latter and the base 2.

Moreover, the BID-side surface of the printed circuit of the base 20 is integrally fixed to a rigid frame 25 that ensures the suitable requirements of planarity of the overall assembly and also allows the mechanical fixing of the base 2 to the BID 5. This rigid frame 25, which may have different geometries and consist of one or more sub-parts, is preferably made of metal.

The cover 3 contains a heater 31 that allows to bring the wafer W to the test temperature, in addition to one or more printed circuits of the cover 30 that electrically connect the heater 31 to the base through the above-mentioned electrical connectors 34 of the cover.

The cover 3 also comprises a system of mechanical pre-alignment 32 of the wafer W with respect to said cover.

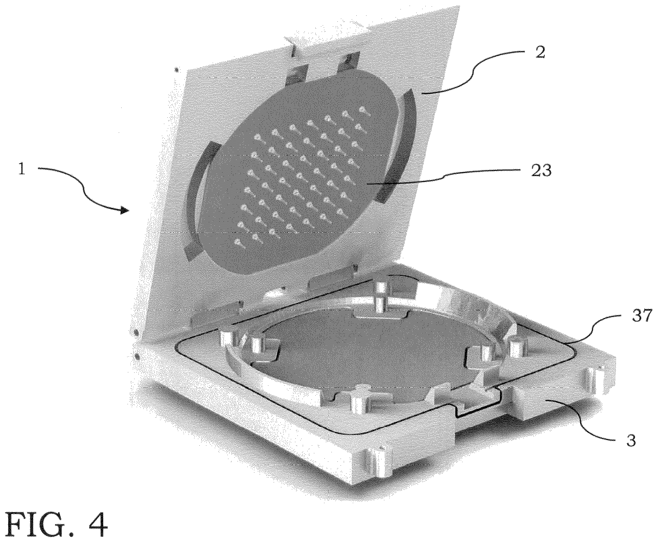

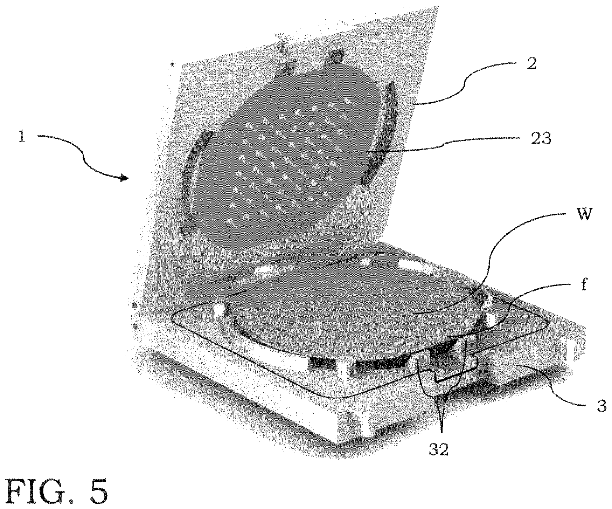

The system of mechanical pre-alignment 32 may be made in various ways depending on the characteristics of the wafer W. Possible examples of solution are: a calibrated pin arranged to align with a notch of the wafer W; or, as shown in Figures 4-6, a guiding profile intended to guide a flat f of the wafer W into the housing seat.

The cover 3, as better described below, also comprises an aspiration system 33 for handling and fixing the wafer W.

The heater 31 inside the cover 3 is a resistor that may be made with various technologies. The heater 31 has several geometrical and specific characteristics of planarity that allow the perfect adhesion of the wafer W to said heater 31 and the possibility to fix the wafer W to the heater 31 by means of pneumatic negative pressure (vacuum) obtained through the ducts of the aspiration system 33 passing through it.

Note that, during operation, the heater 31 is thus in direct contact with the back of the wafer W, thereby allowing maximum efficiency of heat transfer.

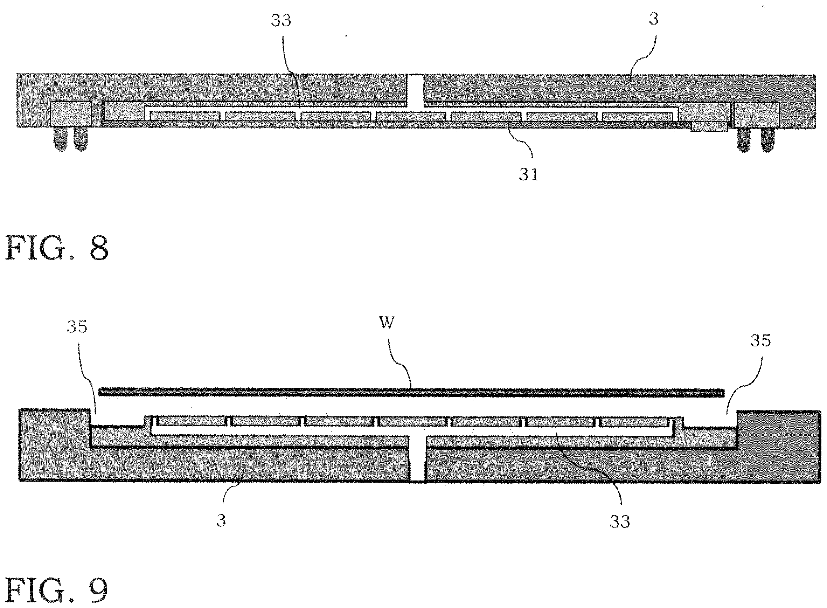

It is also observed that the cover 3 may have, as shown in Figure 9, side indentations 35 that are lateral with respect to the housing seat of the wafer W at the heater 31. Said side indentations 35 allow a robotic handling device provided with grippers to put the wafer W onto the heater 31.

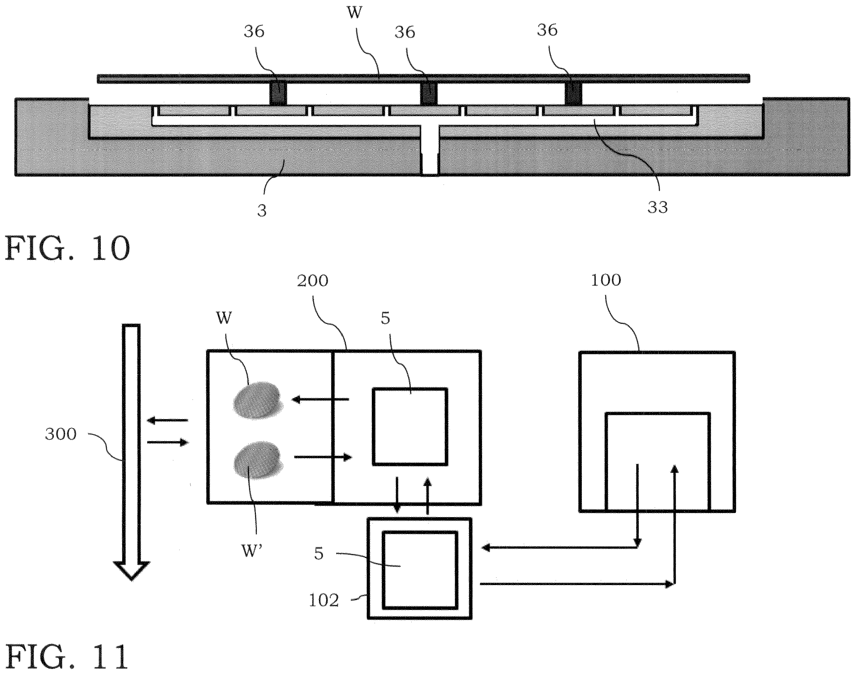

Alternatively, as shown for example in Figure 10, the cover 3 may comprise a set of turrets 36 with pneumatic or mechanical feeding, that are extracted from the surface of the heater 31, so as to allow the grippers of the handling device to put the wafer W onto said turrets without interfering with the Cover. The turrets 36 may then be retracted putting the wafer W in contact with the surface of the heater 31.

A way of loading the shell 1 according to the present invention will be now described.

At the beginning of the process, the shell 1 is open, with base 2 and cover 3 separated. In particular, the base stays preferably fixed on the BID, connected to the latter through upstream electrical connectors of base 24 and suitable mechanical attachments of the rigid frame.

Instead, the cover 3 is preliminarily decoupled from the base 2 by a robotic handling device, and it is held inverted, i.e. in the configuration of Figures 9 and 10, with the surface of the heater 31 facing upwards, by said robotic handling device.

A second robotic handling device positions the wafer W onto the cover 3. The correct positioning is facilitated by the above-mentioned system of mechanical pre-alignment 32, which allows to define the relative position between wafer W and cover 3 with a given degree of accuracy, which is sufficient to ensure the coupling with the cover 3.

A further fine alignment, which will be described below, is still necessary to ensure the alignment between the electrical connectors 24 and 34 of the base 2 and of the cover 3.

The wafer W may be released onto the cover 3 by the robotic handling device in various ways, depending on the characteristics of the wafer W. As previously described, the robotic handling device with grippers may put down the wafer W with direct contact onto the surface of the heater 31 thanks to the side indentations 35 or it may co-operate with the action of the turrets 36.

Once the wafer W has been positioned onto the heater 31 of the cover 3, it is made integral with said cover by applying a pneumatic negative pressure (vacuum) between the surface of the heater 31 and the wafer W. The pressure controls are given through a robotic handling device that handles the cover 3.

As previously mentioned, the aspiration system 33 has the ducts required to transfer the pneumatic control to the surface of said heater 31, where vacuum adhesion occurs.

After the wafer W has been positioned and anchored to the cover 3, an optical alignment may also be carried out which allows then to correctly carry out the positioning of the cover 3 with respect to the base 2.

At this point, the handling device of the cover 3 turns upside down said cover 3 by 180° and couples it with the base 2, calibrating the relative position between the base 2 and the cover 3 based on the feedback received from a vision system, so as to ensure the alignment of the probes 22 of the probe head 23 with the respective pads of the devices on the wafer W.

The cover 3 is then fixed on the base 2, thereby making them integral with each other. Various methods may be used to make the two components integral with each other, for example one-turn screws, spring hooks, single-acting pneumatic pistons. Said devices may be operated by a robotic handling device, not necessarily corresponding to the one handling the cover 3.

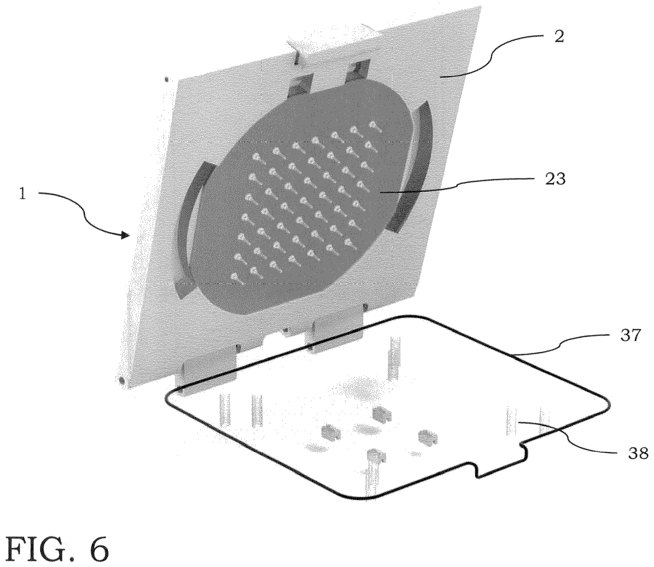

As it is especially shown in Figure 6, there is in particular a gasket 37, particularly in the form of an O-ring, on the outer perimeter between the cover 3 and the base 2. Inner counteracting springs 38 integrated in the cover 3 may also be provided.

The base 2 and the cover 3 are thus aligned with micrometrical resolution by the robotic handling device, based on the feedback of an integrated vision system that identifies the position of the wafer W and of the probes 22 intended to come into contact with the wafer W.

The BIS 100 according to the present invention integrates with a loading/unloading machine 200 for loading/unloading the wafers W from the BIDs 5. The integration of the two systems allows to create a completed cell test that inserts itself into the production flow of the wafers 300, as shown in Figure 11.

The production flow of the resulting test cell may be summarized as follows, starting from drawing the wafers W to be tested in the production process 300.

The new wafers W are inserted by the loading/unloading machine 200 into the BIDs 5, so as to obtain a rack 102 that is completely filled with wafers W to be tested.

The rack is then connected to the BIS 100, that carries out the burn-in test on the wafers W.

The rack 102 with the tested wafers W is then disconnected from the BIS 100 and connected to the loading/unloading machine 200.

The tested wafers W' are removed from the BIDs 5 and introduced again into the production process of the wafers 300.

The test cycle may then be repeated, in synchrony with the production process 300.

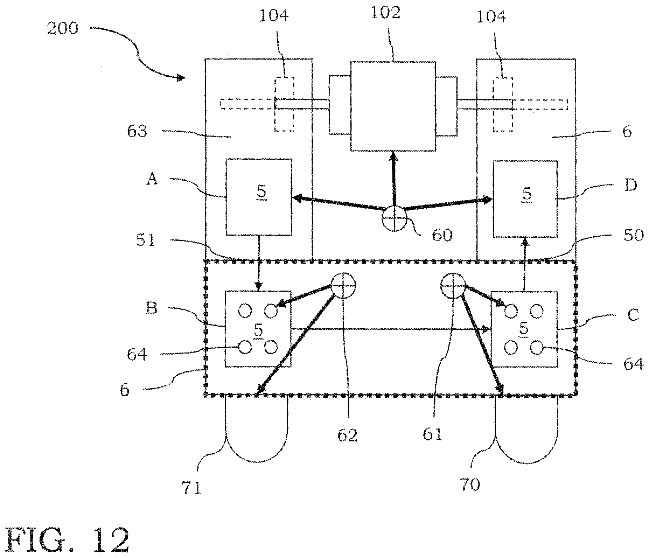

A possible configuration of the loading/unloading machine 200 for loading/unloading the wafers W in the context of the present invention is now described, with specific reference to Figure 12.

First of all, it is noted that the machine 200 has an external area, not subject to specific requirements, and a clean chamber 6 which is in accordance with ESD regulations. The separation between the two areas occurs by means of openable partitions 50, 51 with suitable seal and with a system for air management capable of avoiding that contaminants enter the area for moving the wafers W out of the shells 1.

The loading/unloading system comprises a plurality of FOUPs 70, 71 housed in designated compartments, for both loading and unloading, which are also provided with openable partitions which can be opened once the presence of the container has been detected.

The system may provide a plurality of FOUPS both in input and in output, i.e. only one station of opening of the FOUP, with an automatic vertical loader so as to allow the complete loading/unloading of the many wafers in an automatic way.

In the illustrated embodiment, the clean chamber 6 communicates with an inlet FOUP 70 for loading the wafers W to be tested and an outlet FOUP for unloading the tested wafers W'.

A path of movement of racks 5, in particular on the conveyor belt 63, that enters the clean chamber 6 through an inlet openable partition 51 and exits through an outlet openable partition 50, is also provided.

In particular, the path of movement comprises four successive stations, the first station A, which is external to the clean chamber 6, the second station B and the third station C, which are internal to the clean chamber, the fourth station D, which is again external to the clean chamber 6.

The first station A and the fourth station D are placed at the two sides of the rack 102, which is provided with a locking system 104.

The system also has a first external robotic handling device 60, which is arranged to extract and insert the BID 5 into the housing compartments 103 of the rack 102 with a movement that can also be vertical. In particular, the first robotic handling device 60 positions the BIDs 5 extracted from the rack 102 into the first station A and again inserts the BIDs 5 coming from the fourth station D of the rack 102.

The system also has a second and a third robotic handling device 61, 62 which act at the second and third station B, C, respectively. The second robotic handling device 61 is arranged to load the new wafers W from the inlet FOUP 70 to the BID, the third robotic handling device 62 is arranged to unload the wafers W' from the BID 5 toward the outlet FOUP 71.

Again, at the second and at the third station B, C, there are systems of automatic lifting 64 of the cover 3 of the shells 2, for example by means of a sucker-like grabbing system by vacuum.

The above-described loading/unloading machine 200 has the following operation.

First of all, the rack 102 is manually positioned by an operator into the designated area and it is mechanically connected to an electrohydraulic actuator or similar solution in order to maintain the fixed relative positions.

The operator, through the user interface 101, starts the loading and unloading procedure, according to the preparation instructions of BID 5 and racks 102 received from a centralized control system.

The first robotic handling device 60, dedicated to extract and insert the BIDs 5 into the rack 102, moves vertically up to the first housing compartment 103 to be unloaded, identifying the right housing compartment 103 by means of an optical system.

A first BID 5 is then grabbed by the first robotic handling device 60 and put into the first station A on the conveyor belt 63.

The following description is now about the path of the unloaded BID 5, considering an - obviously non limiting - hypothesis of four total buffering BID 5.

The BID 5 is carried into the clean chamber 6 of the machine, passing through the inlet openable partition 51 which opens as it approaches.

The BID 5 arrives to the second station B, wherein the system of automatic lifting 64 unlocks and lifts the cover 3 of the shell 1.

The third robotic handling device 62 takes the silicon components of the shells 1 and positions them into the outlet FOUP 71 dedicated to the tested wafers W'.

Once unloading has been completed, the covers 3 of the shells 1 are positioned back and the BID is moved toward the third station C.

In the third station C, the covers 3 are opened again by means of the systems of automatic lifting 64.

The second robotic handling device 61 takes the wafers W to be tested from the inlet FOUP 70 and places them into the shells 1 of the BID 5.

Said operation involves the use of an optical system, which has the purpose of pre-aligning the wafer W with the shell 1 and of aligning the pads of the devices that are on the wafer W with the probes 22 of the shell 1.

Once loading has been completed, the covers 3 of the shell 1 are positioned back.

The BID 5 exits then from the clean chamber 6 through the outlet openable partition 50 and reaches the fourth station D.

The first robotic handling device 60 takes the BID 5 and positions it back into its dedicated housing compartment 103 in the rack 102.

The described procedure continues until completion of loading and unloading of all the BIDs 5 that are on the rack 102, as per preloaded instructions.

Then, the rack 102 is released by the locking system 104, the machine signals the end of the unloading and loading procedure and the operator takes the rack 102.

The machine is then ready to unload and load a new rack 102.

Of course, the number of robotic handling devices to be inserted into the clean chamber 6 of the machine and the number of connectable racks 102 may be arbitrarily defined based on the speed of test execution.

Although only selected embodiments were chosen to illustrate the present invention, it will be clear to the skilled person from this disclosure that several changes and modifications may be herein carried out without departing from the scope of the invention as defined in the appended claims.

## Claims

1. Shell (1) for wafer (W) level burn-in chip test, comprising:
- a base (2) configured to connect to a BID (5), comprising a printed circuit of the base (20) electrically connectable to said BID (5) and a probe head (23) provided with a plurality of probes (22) which are intended to contact respective pads of a wafer to be tested (W);
- a cover (3), at least partially separable from said base (2), said cover (3) comprising an integrated heater (31);
wherein, in a test configuration, said cover (3) is rigidly constrained to said base (2) with a wafer to be tested (W) interposed between the base (2) and the cover (3), said heater (31) being configured for heating said wafer to be tested (W) during a burn-in test.

2. Shell (1) according to claim 1, wherein said heater (31) is put directly in contact with the wafer to be tested (W) in the test configuration.

3. Shell (1) according to claim 2, wherein said cover (3) comprises an aspiration system (33) configured to create vacuum in a volume comprised between a wafer-side surface of the heater (31) and the wafer to be tested (W), so as to hold the wafer to be tested (W) against the heater (31).

4. Shell (1) according to claim 3, wherein said aspiration system (33) is integrated in said heater (31), said aspiration system (33) comprising ducts that pass through the wafer-side surface of the heater (31).

5. Shell (1) according to claim 4, wherein said heater (31) comprises a resistor arranged in a volume crossed by said ducts.

6. Shell (1) according to one of the previous claims, wherein said base (2) comprises at least one upstream electrical connector (21) for the electrical connection to the BID and at least one downstream electrical connector (24) for the electrical connection to the cover, said at least one downstream electrical connector (24) being configured to feed said heater (31).

7. Shell (1) according to one of the previous claims, wherein said cover (3) comprises a system of mechanical pre-alignment (32) for guiding a robotic handling device in positioning the wafer to be tested (W) at the heater (31).

8. Shell (1) according to claim 7, wherein said system of mechanical pre-alignment (32) comprises a calibrated pin arranged to align with a notch of the wafer to be tested (W) and/or a guiding profile intended to guide a flat (f) of the wafer to be tested (W) into a housing seat.

9. Shell (1) according to claim 8, wherein said cover (3) comprises side indentations (35) that are lateral with respect to a housing seat of the wafer to be tested (W), said side indentations (35) being configured to allow the grippers of a robotic handling device to access.

10. Shell (1) according to one of the previous claims, wherein said cover (3) comprises turrets (36) that can be extracted with respect to the wafer-side surface of the heater (31) to assist the robotic handling device in positioning the wafer to be tested (W).

11. Movable rack (102) for wafer (W) level burn-in chip test comprising a plurality of housing compartments (104) and a plurality of shells (1) according to any one of the previous claims which can be housed in an extractable way in said housing compartments (104).

12. Burn-in station (100) comprising at least one rack (102) according to claim 11.

13. Method for loading a shell (1) according to any one of claims 1-10, comprising the steps of:
- arranging the shell (1) with base (2) and cover (3) separated from each other;
- orienting said cover (3) with the wafer-side surface of the heater (31) facing upwards;
- positioning, by means of a robotic handling device, a wafer to be tested (W) into a housing seat arranged over said heater (31);
- locking said wafer to be tested (W) in the housing seat on the heater (31);
- positioning the cover (3) with the wafer to be tested (W) over the base (2);
- making the cover (3) integral with the base (2).

14. Method for loading a shell according to claim 11, wherein the step of locking said wafer to be tested (W) in the housing seat on the heater (31) uses an aspiration system.

15. Method for loading a shell according to claim 11 or 12, wherein the step of positioning the wafer to be tested (W) into the housing seat involves a mechanical pre-alignment, followed by a fine alignment by means of a vision system carried out before positioning the cover (3) with the wafer to be tested (W) over the base (2).
